(19) Europäisches Patentamt
European Patent Office
Office européen des brevets

(11) **EP 4 199 123 A1**

(12) **EUROPEAN PATENT APPLICATION**

(43) Date of publication:
**21.06.2023 Bulletin 2023/25**

(21) Application number: **21306854.7**

(22) Date of filing: **20.12.2021**

(51) International Patent Classification (IPC):
*H01L 31/18* (2006.01)    *F21K 9/00* (2016.01)
*H02S 50/15* (2014.01)

(52) Cooperative Patent Classification (CPC):
**H01L 31/186; H01L 31/1876; H02S 50/15**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Commissariat à l'Energie Atomique et aux Energies Alternatives 75015 Paris (FR)**

(72) Inventors:
• **KINFACK LEOGA, Arnaud 38054 GRENOBLE CEDEX 09 (FR)**
• **VEIRMAN, Jordi 38054 GRENOBLE CEDEX 09 (FR)**
• **ROUX, Charles 38054 GRENOBLE CEDEX 09 (FR)**

(74) Representative: **Cabinet Camus Lebkiri 25 rue de Maubeuge 75009 Paris (FR)**

(54) **ELECTROMAGNETIC RADIATION SOURCE AND LIGHT SOAKING SYSTEM COMPRISING SUCH AN ELECTROMAGNETIC RADIATION SOURCE**

(57)    The invention relates to an electromagnetic radiation source (20) designed for a lightsoaking treatment of a photovoltaic cell or a photovoltaic cell precursor, said source comprising a plurality of first radiation emitters (21) and a plurality of second radiation emitters (22), the first and second radiation emitters (21, 22) being arranged in a plurality of rows (Ri), each first radiation emit-ter (21) being configured to emit a first electromagnetic radiation having a spectrum comprised between 300 nm and 550 nm and each second radiation emitter (22) being configured to emit a second electromagnetic radiation having a spectrum comprised between 800 nm and 1200 nm.

**Fig. 3**

## Description

## TECHNICAL FIELD

The present invention relates to an electromagnetic radiation source that may be used to perform a light-soaking treatment of a photovoltaic cell. The present invention also relates to a light soaking system comprising such an electromagnetic radiation source.

## STATE OF THE ART

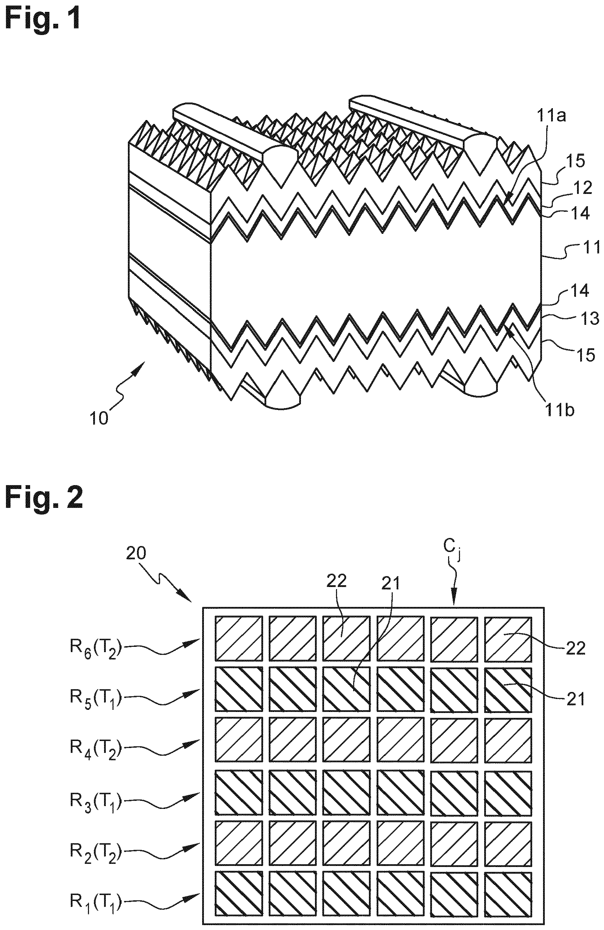

Figure 1 shows an example of a silicon heterojunction (SHJ) photovoltaic cell 10. The photovoltaic cell 10 comprises a doped crystalline silicon substrate 11 and two amorphous silicon layers 12-13 arranged on either side of the substrate 11. One of the amorphous silicon layers 12-13 is doped of the same conductivity type as the substrate 11, such as n-type, and the other layer is doped of the opposite conductivity type, i.e. p-type.

The heterojunction is formed by the n-doped crystalline silicon substrate 11 and the p-doped amorphous silicon layer, this layer forming the emitter of the photovoltaic cell. The emitter may be located on the front face or the back face of the photovoltaic cell.

The SHJ photovoltaic cell is particularly sensitive to defects located at the interface between the crystalline silicon substrate 11 and the amorphous silicon layers 12-13. These defects can be dangling bonds or impurities such as metal ions. They introduce energy levels into the silicon bandgap and increase the number of electron-hole recombinations at the interfaces, which degrades the output parameters of the photovoltaic cell, such as the open circuit voltage Voc.

To achieve a high performance photovoltaic cell, it is therefore necessary to minimize the number of recombinations at the surface of the substrate 11. This is generally accomplished by depositing a passivation layer 14 made of intrinsic hydrogenated amorphous silicon on each side of the substrate 11, prior to the amorphous silicon layer 12, 13. Hydrogen atoms contained in the passivation layers 14 diffuse to the surface of the substrate 11 and neutralize defects.

A transparent conductive oxide (TCO) layer 15 is then deposited on each of the amorphous silicon layers 12-13.

It is known that the energy conversion efficiency of SHJ photovoltaic cells may be improved and stabilize under the combined action of illumination and temperature. This cell "enhancement" phenomenon results from the improvement of at least one of the hydrogenated amorphous silicon passivation layers 14, as well as from the improvement of the interfaces between the amorphous silicon layers 12-13 and the TCO layers 15.

The observation of the enhancement phenomenon of SHJ photovoltaic cells has led to the development of treatment methods comprising a step of exposing the photovoltaic cells to a light radiation. These treatment methods are referred to as light soaking methods.

Document WO2021/018757 discloses a light soaking method comprising a step of exposing a SHJ photovoltaic cell (or a SHJ photovoltaic cell precursor) to an electromagnetic radiation having an irradiance greater than or equal to 200 kW/m$^2$ and at least one wavelength comprised between 400 nm and 1100 nm. This exposing step is accomplished by arranging the photovoltaic cell on a support and under an electromagnetic radiation source. The electromagnetic radiation source may be a laser system comprising one or more laser arrays, an assembly of light emitting diodes or any other illuminating device capable of emitting electromagnetic radiation with an irradiance greater than 200 kW/m$^2$.

## SUMMARY OF THE INVENTION

An objective of the invention is to provide an electromagnetic radiation source that allows to accomplish a light soaking treatment in an efficient way.

According to a first aspect of the invention, this objective is achieved by providing an electromagnetic radiation source designed for a light-soaking treatment of a photovoltaic cell or a photovoltaic cell precursor, said source comprising a plurality of first radiation emitters and a plurality of second radiation emitters, the first and second radiation emitters being arranged in a plurality of rows, each first radiation emitter being configured to emit a first electromagnetic radiation having a spectrum comprised between 300 nm and 550 nm and each second radiation emitter being configured to emit a second electromagnetic radiation having a spectrum comprised between 800 nm and 1100 nm.

In a preferred embodiment, the plurality of rows comprise rows of a first type and rows of a second type alternating with the rows of the first type.

According to a first development of the preferred embodiment, each row of the first type comprises several first radiation emitters and several second radiation emitters alternating with the first radiation emitters and each row of the second type comprises several first radiation emitters and several second radiation emitters alternating with the first radiation emitters.

For example, the first and second radiation emitters are arranged according to a checkerboard pattern.

According to a second development of the preferred embodiment, each row of the first type is composed of the first radiation emitters and each row of the second type is composed of the second radiation emitters.

According to a third development of the preferred embodiment, each row of the first type comprises several first radiation emitters and several second radiation emitters alternating with the first radiation emitters and each row of the second type is composed of the first radiation emitters.

According to a fourth development of the preferred embodiment, each row of the first type comprises several first radiation emitters and several second radiation emitters alternating with the first radiation emitters and each row of the second type is composed of the second radiation emitters.

The electromagnetic radiation source according to the first aspect of the invention may also have one or more of the following characteristics, considered individually or according to any technically possible combinations thereof:

- the first electromagnetic radiation and the second electromagnetic radiation are monochromatic;

- the number of the first radiation emitters is equal to the number of the second radiation emitters;

- the number of the first radiation emitters is strictly greater than the number of the second radiation emitters;

- the number of the first radiation emitters is strictly lower than the number of the second radiation emitters;

- the surface of the second radiation emitters is comprised between 95 % and 105 % of the surface of the first radiation emitters.

- the surface of the second radiation emitters is greater than twice the surface of the first radiation emitters;

- the surface of the first radiation emitters is greater than twice the surface of the second radiation emitters;

- the surface of the first radiation emitters is lower than or equal to $30 \times 30$ mm$^2$ and the surface of the second radiation emitters is lower than or equal to $30 \times 30$ mm$^2$;

- the light power of the first radiation emitters is lower than or equal to 3 W and the light power of the second radiation emitters is lower than or equal to 3 W;

- two consecutive rows of the plurality of rows are offset one another,

- the first and second radiation emitters are light-emitting diodes (LED).

A second aspect of the invention relates to a light soaking system comprising:

- a support configured to receive at least one photovoltaic cell or at least one photovoltaic cell precursor;

- an electromagnetic radiation source according to the first aspect of the invention, the electromagnetic radiation source being facing the support.

In a preferred embodiment of the light soaking system, the support is mobile in translation with respect to the source and configured to transport simultaneously a plurality of photovoltaic cells or a plurality of photovoltaic cell precursors.

According to a development of this preferred embodiment, the light soaking system further comprises a controller configured to adjust the displacement speed of the support as a function of a treatment time of the photovoltaic cells or photovoltaic cell precursors.

According to another development, the controller is further configured to adjust the light power of the first radiation emitters and/or the light power of the second radiation emitters as a function of a temperature of the photovoltaic cells or photovoltaic cell precursors.

The light soaking system preferably comprises a temperature regulation device configured to maintain a temperature of the at least one photovoltaic cell or the at least one photovoltaic cell precursor below a temperature threshold.

The temperature regulation device may comprise an air blowing system and the controller may be further configured to adjust the air speed as a function of the temperature of the at least one photovoltaic cell or the at least one photovoltaic cell precursor.

The light soaking system advantageously comprises a photoluminescence or electroluminescence device configured to capture a photoluminescence or electroluminescence image of the at least one photovoltaic cell or the at least one photovoltaic cell precursor.

A third aspect of the invention relates to a treatment method by light soaking of a photovoltaic cell or of a photovoltaic cell precursor, comprising exposing the photovoltaic cell or photovoltaic cell precursor to the first and second electromagnetic radiations emitted by an electromagnetic radiation source according to the first aspect of the invention.

**BRIEF DESCRIPTION OF THE FIGURES**

Other characteristics and advantages of the invention will become clear from the description that is given thereof below, by way of indication and in no way limiting, with reference to the appended figures, among which:

- figure 1, previously described, is a schematic perspective view of an example of a heterojunction photovoltaic cell;
- figure 2 shows a first embodiment of an electromagnetic radiation source according to the first aspect of the invention;
- figure 3 shows a second embodiment of an electromagnetic radiation source according to the first aspect of the invention;

- figure 4 shows a third embodiment of an electromagnetic radiation source according to the first aspect of the invention;
- figure 5 shows a fourth embodiment of an electromagnetic radiation source according to the first aspect of the invention;
- figure 6 shows a fifth embodiment of an electromagnetic radiation source according to the first aspect of the invention;
- figure 7 shows the irradiance of the radiations emitted by the electromagnetic radiation source according to figure 6;
- figure 8 shows a sixth embodiment of an electromagnetic radiation source according to the first aspect of the invention;
- figure 9 shows a seventh embodiment of an electromagnetic radiation source according to the first aspect of the invention; and
- figure 10 shows a preferred embodiment of a light soaking system according to the second aspect of the invention.

For greater clarity, identical or similar elements are marked by identical reference signs in all of the figures.

## DETAILED DESCRIPTION OF AT LEAST ONE EMBODIMENT

Figures 2-6 and 8-9 show different embodiments of an electromagnetic radiation source 20 suitable for a treatment method by light soaking of a photovoltaic cell. Such a method comprises exposing the photovoltaic cell to an electromagnetic radiation emitted by the source 20, so as to increase the open circuit voltage Voc and decrease the series resistance $R_s$ of the photovoltaic cell. The energy conversion efficiency of the cell is thus improved and stabilized.

The photovoltaic cell may be a silicon heterojunction (SHJ) photovoltaic cell like the photovoltaic cell 10 shown in figure 1 and comprising:

- a substrate 11 made of doped crystalline silicon, for example of n-type crystalline silicon;

- a first passivation layer 14 made of intrinsic hydrogenated amorphous silicon and arranged on a first face 11a of the substrate 11;

- a first doped amorphous silicon layer 12 arranged on the first passivation layer 14;

- a first transparent conductive oxide (TCO) layer arranged on the first doped amorphous silicon layer 12;

- a second passivation layer 14 made of intrinsic hydrogenated amorphous silicon and arranged on a second face 11b of the substrate 11;

- a second doped amorphous silicon layer 13 arranged on the second passivation layer 14; and

- a second transparent conductive oxide layer arranged on the second doped amorphous silicon layer 13.

The first and second amorphous silicon layers 12-13 are doped of opposite conductivity type. The amorphous silicon of the first and second doped layers 12-13 may be hydrogenated.

With reference to figures 2-6 and 8-9, the source 20 comprises a plurality of first radiation emitters 21 and a plurality of second radiation emitters 22. Each of the first radiation emitters 21 is configured to emit a first electromagnetic radiation having a spectrum comprised between 300 nm and 550 nm (limits included), and preferably between 400 nm and 450 nm (limits included). The first electromagnetic radiation has a spectrum limited to the 300-500 nm range (in other words, all the wavelengths are comprised between 300-500 nm range), preferably to the 400-450 nm range. Given their emission spectrum, the first radiation emitters 21 are referred to as blue/near ultraviolet light sources.

The first electromagnetic radiation may be monochromatic or polychromatic. A radiation is considered to be monochromatic when it has only one line (or component) having a full width at half maximum (FWHM) lower than or equal to 10 nm. Conversely, a radiation is considered to be polychromatic when it has several lines (or components) or when the full width at half maximum (FWHM) of the single line is greater than 10 nm.

Preferably, the first radiation emitters 21 have substantially the same size and substantially the same light power density (also called irradiance, in W/m²). "Substantially" means that the size/density difference between the first radiation emitters 21 does not exceed 5 %.

Each of the second radiation emitters 22 is configured to emit a second electromagnetic radiation having a spectrum comprised between 800 nm and 1200 nm (limits included), and preferably between 900 nm and 1100 nm (limits included). The second electromagnetic radiation may be monochromatic or polychromatic. It has a spectrum limited to the 800-1200 nm range, preferably to the 900-1100 nm range. Given their emission spectrum, the second radiation emitters 22 are referred to as near infrared light sources.

Preferably, the second radiation emitters 22 have substantially the same size and substantially the same light power density (or irradiance). "Substantially" means that the size/density difference between the second radiation emitters 22 does not exceed 5%.

Exposing a photovoltaic cell (such as that shown in figure 1) to both the first and the second radiations improve the kinetics and amplitude of the conversion efficiency gain while limiting the heating of the cell. This enables the treatment time necessary to obtain a given efficiency gain to be decreased, which is interesting in order to meet the throughput requirement of a photovoltaic cell manufacturing line.

The first radiation (between 300-550 nm) is absorbed at least partially in the first few hundred nanometers of the photovoltaic cell, which significantly improves the quality of the layers arranged on the exposed side of the photovoltaic cell (in the example above, one of the doped amorphous silicon layers 12-13, the passivation layer 14 and the transparent conductive oxide layer 15), as well as the quality of their interfaces. The exposed side of the photovoltaic cell is for example the n-side, i.e. the side where is arranged the n-doped amorphous silicon layer.

The very short wavelengths, below 400 nm, are very energetic and may degrade the passivation layer. Restricting the wavelength range between 400 nm and 550 nm limits the risk of degradation of the passivation layer. However, the longer the wavelength of the first radiation, the less efficiently the first radiation is absorbed. The wavelength range between 400 nm and 450 nm represents a good compromise between the absorption of the first radiation (and thus the treatment efficiency) and the risk of degradation of the amorphous silicon.

Mixing the first radiation with the second radiation (between 800-1200 nm) limits the heating of the photovoltaic cell which could degrade the amorphous silicon. Indeed, the second radiation is less energetic than the first radiation but contributes to the conversion efficiency gain. The second radiation is absorbed at least in part into the crystalline substrate 11, resulting in a decrease in the number of interface states between the crystalline substrate 11 and the passivation layers 14 arranged on both sides of the crystalline substrate 11. In other words, the number of neutralized interface defects increases and the quality of the passivation improves. The wavelength range between 900 and 1100 nm represents a good compromise between the absorption of the second radiation and the heating of the cell.

The first radiation emitted by the first radiation emitters 21 has a first light power density $E_1$ and the second radiation emitted by the second radiation emitters 22 has a second light power density $E_2$. A ratio R between the first light power density $E_1$ and the second light power density $E_1$ may be comprised between 10/90 and 90/10, preferably between 30/70 and 70/30. The ratio R is chosen in function of the technology of the photovoltaic cell to be treated. It is defined as follows:

$$R = \frac{E_1}{E_2} = \frac{f_1 \times E_T}{f_2 \times E_T}$$

where $E_T$ is the total light power density of the overall radiation emitted by the source 20, fi is the fraction (or percentage) of the first radiation in the overall radiation and $f_2$ is the fraction of the second radiation in the overall radiation.

The total light power density $E_T$ may be greater than or equal to 10kW/m². It is preferably equal to the sum of the first light power density $E_1$ and the second light power density $E_2$ (i.e. fi + $f_2$ = 1). In other words, the source 20 comprises no more radiation emitters than the first radiation emitters 21 and the second radiation emitters 22. In particular, the source 20 may be devoid of radiation emitter emitting at a wavelength strictly greater than 550 nm and strictly lower than 800 nm, such that the light power density in the 550 - 800 nm range (excluding the limits) is zero.

The first and second radiation emitters 21-22 may be light-emitting diodes (LED) or lasers. LED are cheaper than lasers, especially for high light power densities (> 10 kW/m²).

For the sake of simplicity, the first and second radiation emitters 21-22 will be considered hereafter to be LED. Consequently, the first radiation emitters 21 will be designated "first LED" and the second radiation emitters 22 will be designated "second LED".

The first and second LED 21-22 of the source 20 are arranged so as to form a plurality of row $R_i$ (the index i being a natural integer comprised between 1 and N, N being the total number of rows). The different rows $R_i$ preferably comprise the same number of LED. In the embodiments of figures 2-3, 6 and 8-9, the first and second LED 21-22 are further arranged to form a plurality of columns Cj oriented perpendicularly to the row $R_i$ (the index j being a natural integer comprised between 1 and M, M being the total number of columns). The source 20 then comprises an array of LED (said array being preferably comprised of first and second LED 21-22).

The row $R_i$ of LED are preferably parallel to each other. The distance between two consecutive rows $R_i$ may be comprised between 0 mm (i.e. the rows are adjacent) and 20 mm. Advantageously, the rows $R_i$ are regularly spaced apart from each other. The distance between two consecutive LED in a row $R_i$ may be comprised between 0 mm (i.e. the LED are adjacent) and 20 mm. It is also advantageous that, in each row $R_i$, the LED are regularly spaced apart from each other. A constant distance between the rows $R_i$ or between the LED in each row $R_i$ improves the homogeneity of the radiation emitted by the source 20.

The first and second LED 21-22 are preferably mounted on a printed circuit board (PCB). They may have a square-shape packaging, as shown in the figures. Alternatively, the packaging may be rectangular, circular or hexagonal.

In the embodiments of figures 2-6, the source 20 comprises rows $R_i$ of a first type $T_1$ and rows $R_i$ of a second type $T_2$ (different from the first type $T_1$). The rows $R_i$ of the second type $T_2$ are arranged alternately with the rows $R_i$ of the first type $T_1$. Such an arrangement makes the radiation of the source 20 more homogeneous, compared to the case where the LED are arranged randomly. The light soaking treatment of the solar cell is thus improved.

More particularly, in the embodiment of figure 2, each row $R_i$ of the first type $T_1$ is composed of the first LED 21 and each row $R_i$ of the second type $T_2$ is composed of the second LED 22. This arrangement facilitates the manufacturing of the source 20, because the LED may be provided in the form of strips.

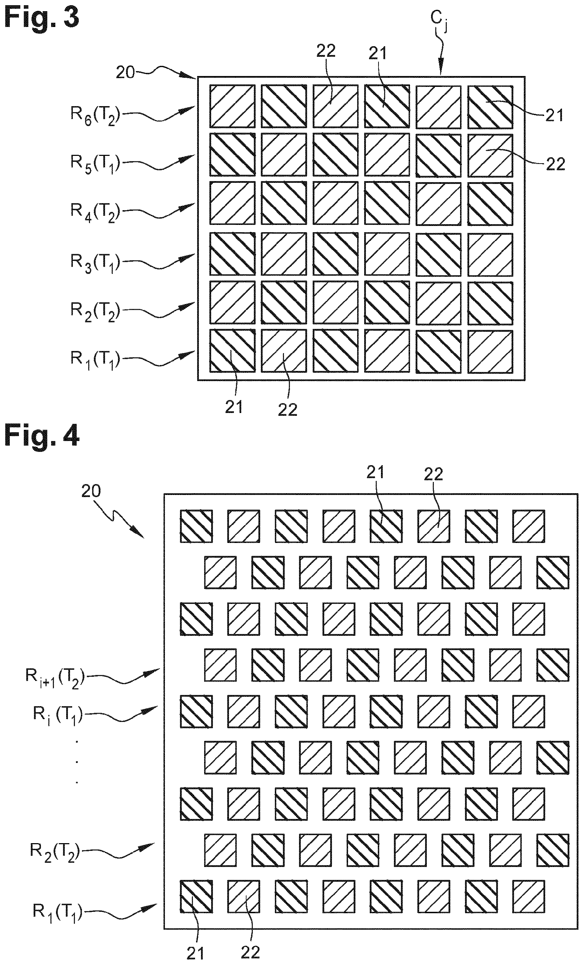

In the embodiments of figures 3 and 4, each row $R_i$ of the first type $T_1$ and each row $R_i$ of the second type $T_2$ comprise several first LED 21 and several second LED 22 alternating with the first LED 21. A row of the first type $T_1$ and a row of the second type $T_2$ start with different LED. For example, the most left LED of each row of the first type $T_1$ is a first LED 21, whereas the most left LED of each row of the second type $T_2$ is a second LED 22. As shown in figure 3, the first LED 21 and the second LED 22 may be arranged according to a checkerboard pattern.

These two embodiments offer the best radiation homogeneity (for a given size of LED) since the alternation between the first LED 21 and the second LED 22 is more frequent (from one row to the other, like in figure 2, and in the direction of the rows). However, the manufacturing of the source 20 is more complex because it requires to provide and assemble individual LED (instead of LED strips).

The number of first LED may be equal to the number of second LED, as shown in figures 2 to 4. When the first LED 21 and the second LED 22 have the same light power density and the same size, it is the simplest way to achieve a light power density ratio R equal to 1 (or 50/50).

The number N1 of first LED 21 and the number N2 of second LED 22 may be calculated as follows:

$$N1 = \frac{P_{T1}}{P_{LED1}} = \frac{E_1 \times S}{P_{LED1}}$$

where $P_{T1}$ is the total light power of the first LED 21, $P_{LED1}$ is the light power of one first LED 21, $E_1$ is the first light power density and S is the emission surface of the source 20 (i.e. the surface available to accommodate the first and second LED 21-22); and

$$N2 = \frac{P_{T2}}{P_{LED2}} = \frac{E_2 \times S}{P_{LED2}}$$

where $P_{T2}$ is the total light power of the second LED 22, $P_{LED2}$ is the light power of one second LED 22 and $E_2$ is the second light power density.

In the embodiments of figures 2-3, the first and second LED 21-22 have a large surface, typically greater than 30 x 30 mm², and a high light power, typically greater than 200 W. As an example, the first light power density $E_1$ of the first radiation and the second light power density $E_2$ of the second radiation are chosen equal to 24 kW/m² each ($E_T$ = 48 kW/m²). The source 20 comprises eighteen first LED 21 and eighteen second LED 22 in a square emission surface S of 30 x 30 cm². Each of the first and second LED 21-22 has a square surface equal to 40 x 40 mm² and a light power of 120 W. The first LED 21 occupy 32 % of the emission surface S and the second LED occupy 32 % of the emission surface S.

In the embodiment of figure 4, the first and second LED 21-22 have a low surface, typically lower than or equal to 30 x 30 mm², and a low light power, typically lower than or equal to 200 W. To achieve the same total light power density $E_T$ of 48 kW/m² with LED having a 20 x 20 mm² surface and a 60W light power, the number N1 of the first LED 21 and the number N2 of the second LED 22 must be equal to 36. Consequently, the first LED 21 occupy 16 % of the emission surface S (still equal to 30 x 30 cm²) and the second LED occupy 16 % of the emission surface S.

From a radiation homogeneity point of view, it is preferable that the source 20 comprises high numbers N1, N2 of LED having a low surface than low numbers N1, N2 of LED having a high surface. Preferably, the first and second LED 21-22 occupy at least 30 % of the emission surface S.

In summary, the arrangement in rows composed of the same LED (Fig.2) is not optimal from the point of view of radiation homogeneity. By adopting a checkerboard configuration (or the like) and alternating the LEDs of different types (Fig.3), the radiation homogeneity can be greatly increased. When, in addition to the checkerboard pattern, smaller LEDs are used (Fig.4), it is possible to further improve the radiation homogeneity.

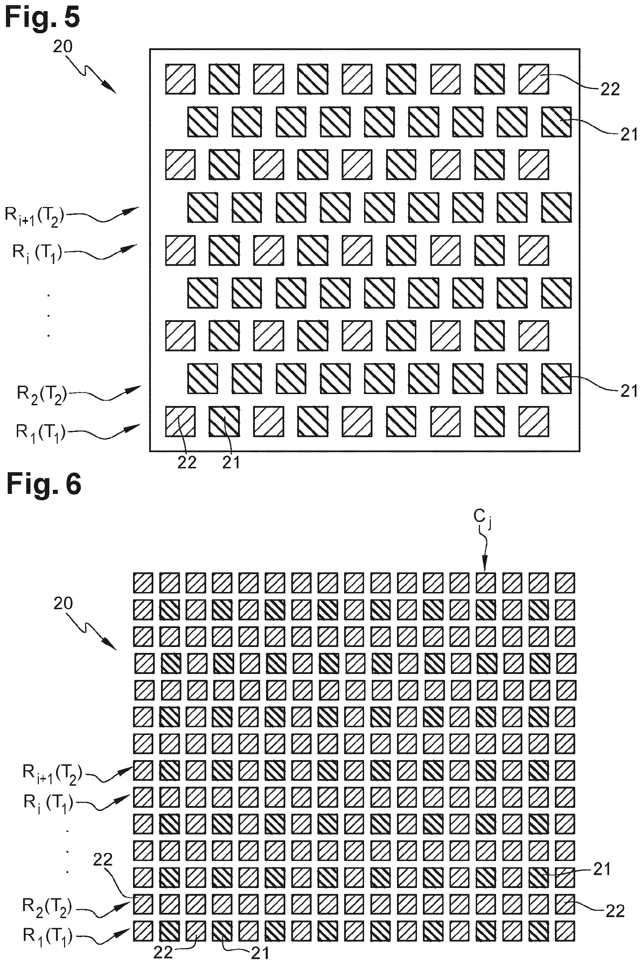

In the embodiment of figure 5, the number of first LED 21 is strictly greater than the number of second LED 22. This allows to easily achieve a light power density ratio R greater than 1. To obtain nevertheless a high radiation homogeneity, each row of the first type $T_1$ may comprise several first LED 21 and several second LED 22 alternating with the first LED 21 and each row of the second type $T_2$ may be composed of the first LED 21. As an example, a first light power density $E_1$ of 33,6 kW/m² and a second light power density $E_2$ of 14,4 kW/m² (R = 70/30 and $E_T$ still 48 kW/m²) may be achieved by providing 50 first LED 21 (20 x 20 mm²; 60 W) and 22 second LED 22 (20 x 20 mm²; 60 W) in a 30 x 30 cm² emission surface S.

In the embodiment of figure 6, the number of first LED 21 is on the contrary strictly lower than the number of second LED 22. This allows to easily achieve a light power density ratio R lower than 1. To obtain nevertheless a high radiation homogeneity, each row of the first type $T_1$ may comprise several first LED 21 and several second LED 22 alternating with the first LED 21 and each row of the second type $T_2$ may be composed of the second LED 22.

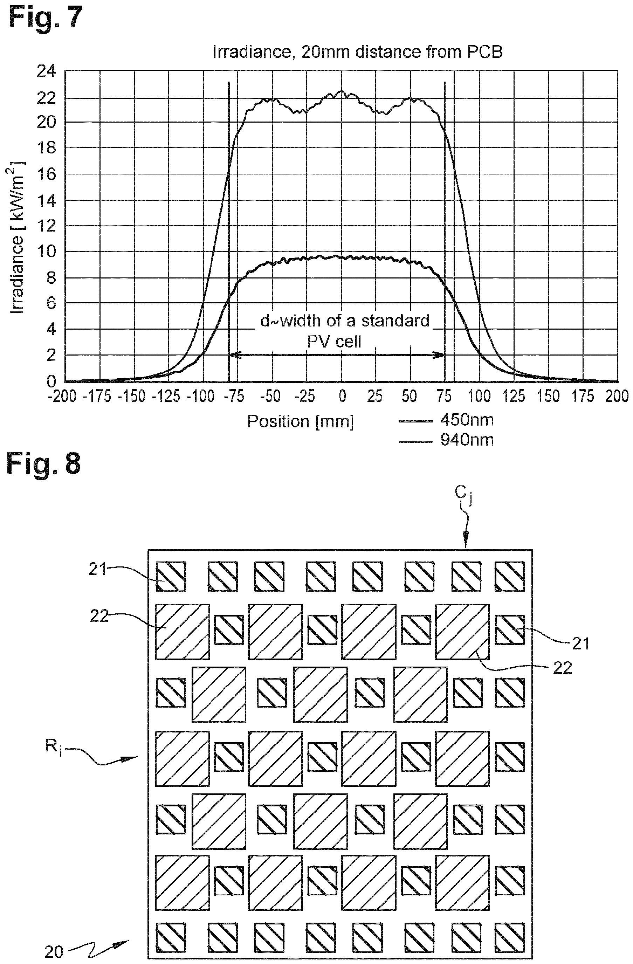

Figure 7 represents the irradiance of the first and second radiations emitted by an example of source 20 according to the embodiment of figure 6, as a function of the distance from the center of the LED array. In this example, the source 20 comprises 330 first LED 21 (wavelength: 450 nm; LED surface: 3.45 x 3.45 mm$^2$; electric power: 2.3 W) and 600 second LED 22 (wavelength: 940 nm; LED surface:3.85 x 3.85 mm$^2$; electric power: 3.5 W) in an 18 x 18 cm$^2$ emission surface S.

The irradiance is simulated at 20 mm from the PCB of the LED. As expected, the irradiance $E_2$ of the second radiation is higher than the irradiance $E_1$ of the first radiation. One can also notice that the irradiance $E_1$ of the first radiation and the irradiance $E_2$ of the second radiation are substantially constant (variation of less than 20 %) over a distance d of about 160 mm, this distance d being centered on the center of the LED array. The distance d corresponds to the width of a standard cell (square or pseudo-square of 156 mm side). It follows that a standard cell can receive a substantially homogenous radiation from the source 20. The radiation homogeneity can be further improved by increasing the size of the LED array, in order to limit the edge effects (LEDs are in practice components with very divergent lighting).

The greater the distance between the source and the photovoltaic cell, or the greater the emission angle of the LED, the greater the homogeneity of the radiation received by the photovoltaic cell.

In the embodiments of figures 2 to 6, the first and second LED 21-22 have substantially the same size and substantially the same light power. More particularly, the surface of the second LED 22 is comprised between 95 % and 105 % of the surface of the first LED 21. The light power of the second LED 22 is comprised between 95 % and 105 % of the light power of the first LED 21.

It is however possible to use LED of different sizes and/or light powers. In the embodiment of figure 8, the second LED 22 have a surface (and a light power) greater than the surface (light power) of the first LED 21, and preferably of at least twice the surface (light power) of the first LED 21. For example, the surface of the first LED 21 may be 20 x 20 mm$^2$ and the surface of the second LED 22 may be 40 x 40 mm$^2$. A high radiation homogeneity may still be achieved by alternating the first LED 21 and the second LED 22, as explained before.

In an alternative embodiment, not shown in the figures, the first LED 21 have a surface (and a light power) greater than the surface (light power) of the second LED 22, and preferably of at least twice the surface (light power) of the second LED 22.

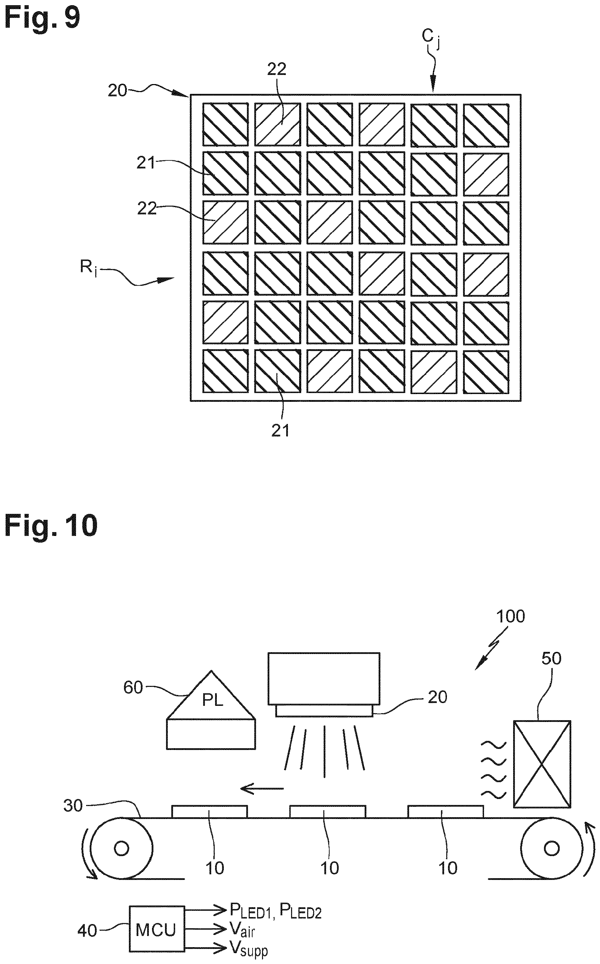

In the embodiment of figure 9, the number of first LED 21 is strictly greater than the number of second LED 22. Each row $R_i$ and each column Cj of the LED array comprise at least one second LED 22. The second LED 22 may be located in the vicinity of the center of the LED array and adjacent to the edges of the LED array.

The different rows of the source 20 may be aligned in the direction of the columns Cj, as shown in figures 2-3, 6, 8-9, or two consecutive rows (one of the first type $T_1$ and one of the second type $T_2$) may be offset one another, as shown in figures 4 and 5. The offset between two consecutive rows may be comprised between 1 mm and half the distance between two consecutive LEDs in the row. An offset provides a better overall spatial homogeneity.

In addition to the first LED 21 and the second LED 22, the source 20 may further comprise a power supply and a (LED) driver. The power supply is connected to the first and second LED 21-22 through the driver. The driver distributes the electric power of the power supply between the group of first LED 21 and the group of second LED 22. The driver is advantageously configured to control the electric power of the first LED 21 independently of the electric power of the second LED 22, thus making the power distribution variable. This enables the light power of the LED to be adjusted, for example to compensate a more pronounced ageing of one of the LED groups.

The LED array may be composed of modules, each module comprising at least one row $R_i$ of LED. The modules are electrically connected in parallel. In each module, the LED are electrically connected in series. The modules are removably connected to a socket. Such a configuration simplifies the maintenance of the electromagnetic radiation source 20 (and reduces its cost), since a defective LED can be easily replaced by changing the module to which it belongs.

As described previously, the source 20 may be used for the light soaking treatment of SHJ photovoltaic cell, such as the photovoltaic cell 10 of figure 1. The photovoltaic cell 10 may be exposed regardless of the orientation of the cell (i.e. the first face 11a or the second face 11b may be oriented towards the source 20). The light soaking treatment may also be applied to an interdigitated back contact SHJ photovoltaic cell (IBC-HET). Indeed, the IBC-HET photovoltaic cell comprise an hydrogenated intrinsic amorphous silicon (i:a-Si) layer stacked with doped amorphous silicon layers (n-type and p-type on the same face of the crystalline silicon substrate) and with a TCO layer.

A light soaking treatment by means of the source 20 may also be interesting for an SHJ-based tandem photovoltaic cell. A SHJ-based tandem photovoltaic cell comprises a SHJ sub-cell (referred as the bottom cell) and a perovskite sub-cell arranged on the SHJ sub-cell (and referred as the top cell). The first electromagnetic radiation (blue/near UV radiation) emitted by the first LED 21 is mainly absorbed by the perovskite sub-cell, whereas the second electromagnetic radiation (near IR radiation) emitted by the second LED 22 is mainly absorbed by the SHJ sub-cell. The treatment makes it possible to heal defects in both the sub-cells.

Finally, the source 20 may also be used for the light soaking treatment of silicon homojonction photovoltaic cell.

The light soaking treatment may be performed at the end of the method of manufacturing the photovoltaic cells (i.e. on finished photovoltaic cells) or during the method of manufacturing the photovoltaic cells, with a stack of layers commonly called a photovoltaic cell precursor. For example, a precursor of a SHJ photovoltaic cell comprises the crystalline silicon substrate 11 (n-type or p-type) and at least one passivation layer made of hydrogenated amorphous silicon and arranged on a face of the substrate 11. The photovoltaic cell precursor is preferably exposed with the passivation layer oriented towards the source 20 (for the blue/UV absorption in the passivation layer).

The light soaking treatment of the photovoltaic cells may also be performed when the photovoltaic cells are electrically connected in a string or into a photovoltaic panel.

Figure 10 shows a preferred embodiment of a light soaking system 100 according to another aspect of the invention. The light soaking system 100 comprises the electromagnetic radiation source 20 and a support 30 configured to receive at least one photovoltaic cell or at least one photovoltaic cell precursor (reference is made below to the photovoltaic cell 10 of figure 1). The source 20 is facing the support 30.

In this preferred embodiment, the support 30 is mobile in translation with respect to the source 20 and configured to transport simultaneously a plurality of photovoltaic cells (or a plurality of photovoltaic cell precursors). The photovoltaic cells 10 are successively moved in front of the source 20 by the support 30. The LED array of the source 20 may be dimensioned to expose simultaneously several photovoltaic cells. The mobile support 30 is preferably a conveyor (for example a belt conveyor or a chain conveyor).

A source 20 according to the embodiment of figure 2 is interesting in the case of a mobile support 30 (as interesting than the embodiments alternating the first and second LED 21-22) provided that the row Ri of LED are oriented perpendicularly to the movement direction.

Preferably, the light soaking system 100 further comprises a controller 40 (or control circuit) configured (or programmed) to adjust the displacement speed $V_{supp}$ of the support 30 as a function of the treatment time of the photovoltaic cells 10. The displacement speed $V_{supp}$ of the support 30 (and thus of the photovoltaic cells 10) is indeed calculated as a function of the desired treatment time (for example comprised between 5 s and 60 s), given the length of the LED array in the movement direction. The controller 40 may be a microcontroller (or MCU, for microcontroller unit).

In alternative embodiments (not shown), the support 30 is stationary with respected to the source 20 or is mobile in rotation with respect to the source 20.

The light soaking system 100 may further comprise a temperature regulation device 50 configured to maintain the temperature of the photovoltaic cell(s) 10 below a temperature threshold. The temperature threshold is for example equal to the temperature above which the amorphous silicon of the photovoltaic cell 10 is degraded. This threshold may be comprised between 200 °C and 320 °C (depending on the technique used to deposit the material).

The temperature regulation device 50 may comprise an air blowing system to cool the photovoltaic cell 10. The air blowing system is preferably servo-controlled by means of the controller 40 and a sensor measuring the temperature of the photovoltaic cell 10. The sensor, for example a pyrometer, is connected to the controller 40. In other words, the controller 40 is further configured to adjust the air speed $V_{air}$ as a function of the temperature of the photovoltaic cell 10.

Another way to regulate the temperature is to contact the photovoltaic cell 10 (for instance using air sucking) to a temperature-regulated part (typically a metallic part).

Instead or in addition, the controller 40 may be further configured to adjust the light power $P_{LED1}$ of the first LED 21 and/or the light power $P_{LED2}$ of the second LED 22 as a function of the temperature of the photovoltaic cell 10.

Finally, the light soaking system 100 may also comprise a photoluminescence or electroluminescence device 60 configured to capture a photoluminescence/electroluminescence image of the photovoltaic cell 10 after it has been exposed to the electromagnetic radiation emitted by the source 20. In the preferred embodiment of the light soaking system 100, the imaging device 60 is then located downstream of the source 20 (in the direction of movement of the cells).

Measuring the photoluminescence or electroluminescence intensity is a simple method to evaluate the benefits of the light soaking method. Indeed, the photoluminescence (respectively electroluminescence) intensity is representative of the open circuit voltage Voc (respectively of the series resistance $R_s$) of the photovoltaic cell.

An additional photoluminescence (electroluminescence) device (not shown in the figure) may be located upstream of the source 20 to determine the variation of the open circuit voltage Voc (of the series resistance $R_s$) during the exposition.


**Claims**

1. Electromagnetic radiation source (20) designed for a light-soaking treatment of a photovoltaic cell or a photovoltaic cell precursor, said source comprising a plurality of first radiation emitters (21) and a plurality of second radiation emitters (22), the first and second radiation emitters (21, 22) being arranged in a plurality of rows ($R_i$), each first radiation emitter (21) being configured to emit a first electromagnetic radiation having a spectrum comprised between 300 nm and 550 nm and each second radiation emitter (22) being configured to emit a second electromagnetic radiation having a spectrum comprised between 800 nm and 1200 nm.

2. Electromagnetic radiation source (20) according to claim 1, wherein the first electromagnetic radiation and the second electromagnetic radiation are monochromatic.

3. Electromagnetic radiation source (20) according to claim 1 or 2, wherein the plurality of rows ($R_i$) comprise rows of a first type ($T_1$) and rows of a second type ($T_2$) alternating with the rows of the first type.

4. Electromagnetic radiation source (20) according to claim 3, wherein each row ($R_i$) of the first type ($T_1$) comprises several first radiation emitters (21) and several second radiation emitters (22) alternating with the first radiation emitters and wherein each row ($R_i$) of the second type ($T_2$) comprises several first radiation emitters (21) and several second radiation emitters (22) alternating with the first radiation emitters.

5. Electromagnetic radiation source (20) according to any one of claim 1 to 4, wherein the first and second radiation emitters (21-22) are arranged according to a checkerboard pattern.

6. Electromagnetic radiation source (20) according to claim 3, wherein each row ($R_i$) of the first type ($T_1$) is composed of the first radiation emitters (21) and each row ($R_i$) of the second type ($T_2$) is composed of the second radiation emitters (22).

7. Electromagnetic radiation source (20) according to claim 3, wherein each row ($R_i$) of the first type ($T_1$) comprises several first radiation emitters (21) and several second radiation emitters (22) alternating with the first radiation emitters and wherein each row ($R_i$) of the second type ($T_2$) is composed of the first radiation emitters (21).

8. Electromagnetic radiation source (20) according to claim 3, wherein each row ($R_i$) of the first type ($T_1$) comprises several first radiation emitters (21) and several second radiation emitters (22) alternating with the first radiation emitters and wherein each row ($R_i$) of the second type ($T_2$) is composed of the second radiation emitters (22).

9. Electromagnetic radiation source (20) according to any one of claim 1 to 8, wherein two consecutive rows ($R_i$) of the plurality of rows are offset one another.

10. Light soaking system (100) comprising:

- a support (30) configured to receive at least one photovoltaic cell (10) or at least one photovoltaic cell precursor;
- an electromagnetic radiation source (20) according to any one of claims 1 to 9, the electromagnetic radiation source (20) being facing the support (30).

11. Light soaking system (100) according to claim 10, wherein the support (30) is mobile in translation with respect to the source (20) and configured to transport simultaneously a plurality of photovoltaic cells (10) or a plurality of photovoltaic cell precursors.

12. Light soaking system (100) according to claim 11, further comprising a controller (40) configured to adjust the displacement speed ($V_{supp}$) of the support (30) as a function of a treatment time of the photovoltaic cells (10) or photovoltaic cell precursors.

13. Light soaking system (100) according to claim 12, wherein the controller (40) is further configured to adjust the light power ($P_{LED1}$) of the first radiation emitters (21) and/or the light power ($P_{LED2}$) of the second radiation emitters (22) as a function of a temperature of the photovoltaic cells (10) or photovoltaic cell precursors.

14. Light soaking system (100) according to any one of claims 10 to 13, further comprising a temperature regulation device (50) configured to maintain a temperature of the at least one photovoltaic cell (10) or the at least one photovoltaic cell precursor below a temperature threshold.

15. Light soaking system (100) according to any one of claim 10 to 14, further comprising a photoluminescence or electroluminescence device (60) configured to capture a photoluminescence or electroluminescence image of the at least one photovoltaic cell (10) or the at least one photovoltaic cell precursor.

16. Treatment method by light soaking of a photovoltaic cell or of a photovoltaic cell precursor, comprising exposing the photovoltaic cell or photovoltaic cell precursor to the first and second electromagnetic radiations emitted by an electromagnetic radiation source (20) according to any one of claims 1 to 15.

# Fig. 1

# Fig. 2

# Fig. 3

$R_6(T_2)$
$R_5(T_1)$
$R_4(T_2)$
$R_3(T_1)$
$R_2(T_2)$
$R_1(T_1)$

20
22
21
$C_j$
21
22
21
22

# Fig. 4

20
21
22

$R_{i+1}(T_2)$
$R_i(T_1)$
$R_2(T_2)$
$R_1(T_1)$

21
22

# Fig. 5

20

22

21

$R_{i+1}(T_2)$

$R_i(T_1)$

.
.
.

$R_2(T_2)$

$R_1(T_1)$

21

22  21

# Fig. 6

$C_j$

20

$R_{i+1}(T_2)$

$R_i(T_1)$

.
.
.

$R_2(T_2)$

$R_1(T_1)$

22

21

22

22    21

# Fig. 7

**Irradiance, 20mm distance from PCB**

d~width of a standard PV cell

Position [mm]

—— 450nm
—— 940nm

# Fig. 8

# Fig. 9

# Fig. 10

Europäisches
Patentamt

European
Patent Office

Office européen
des brevets

# EUROPEAN SEARCH REPORT

**Application Number**

EP 21 30 6854

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/241719 A1 (SHR REN CHIN [TW] ET AL) 6 October 2011 (2011-10-06) * the whole document * | 1-16 | INV. H01L31/18 F21K9/00 H02S50/15 |
| X | ESEN VEDAT ET AL: "Toward Class AAA LED Large Scale Solar Simulator With Active Cooling System for PV Module Tests", IEEE JOURNAL OF PHOTOVOLTAICS, IEEE, vol. 12, no. 1, 21 October 2021 (2021-10-21), pages 364-371, XP011895204, ISSN: 2156-3381, DOI: 10.1109/JPHOTOV.2021.3117912 [retrieved on 2021-12-21] * the whole document * | 1-16 | |
| X | NOVICKOVAS ALGIRDAS ET AL: "Compact Light-Emitting Diode-Based AAA Class Solar Simulator: Design and Application Peculiarities", IEEE JOURNAL OF PHOTOVOLTAICS, IEEE, vol. 5, no. 4, 1 July 2015 (2015-07-01), pages 1137-1142, XP011585334, ISSN: 2156-3381, DOI: 10.1109/JPHOTOV.2015.2430013 [retrieved on 2015-06-18] * the whole document * | 1-16 | **TECHNICAL FIELDS SEARCHED (IPC)** H01L F21V F21K H02S |
| A | US 2015/270431 A1 (FARRIS III CHESTER A [US] ET AL) 24 September 2015 (2015-09-24) * paragraph [0057] - paragraph [0063]; figure 14 * | 1-16 | |

The present search report has been drawn up for all claims

| Place of search | Date of completion of the search | Examiner |
|---|---|---|
| Berlin | 2 June 2022 | Voignier, Vincent |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 30 6854

02-06-2022

| Patent document cited in search report | Publication date | Patent family member(s) | Publication date |
|---|---|---|---|
| US 2011241719 A1 | 06-10-2011 | TW 201135263 A<br>US 2011241719 A1 | 16-10-2011<br>06-10-2011 |
| US 2015270431 A1 | 24-09-2015 | US 2015270431 A1<br>WO 2015143035 A1 | 24-09-2015<br>24-09-2015 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021018757 A